# EUROPEAN PATENT APPLICATION

(11) **EP 1 858 166 A1**
(43) Date of publication of application: **21.11.2007**
(21) Application number: 06714534.2
(22) Date of filing: 24.02.2006
(51) Int. Cl.: H03M 1/12, H01L 21/822, H01L 27/04

(54) **SEMICONDUCTOR DEVICE**

(30) Priority: 10.03.2005 JP 2005066522
(71) Applicant: Niigata Seimitsu Co., Ltd., Jouetsu-shi, Niigata 943-0834 (JP); Ricoh Company, Ltd., Tokyo 143-8555 (JP)
(72) Inventor: MIYAGI, Hiroshi, o 2-chome, Joetsu-shi, Niigata 9430834 (JP); IKEDA, Takeshi, o 2-chome, Joetsu-shi, Niigata 9430834 (JP)
(74) Representative: Murgatroyd, Susan Elizabeth
(86) International application number: PCT/JP2006/303395
(87) International publication number: WO 2006/095581

(57) **Abstract**

A semiconductor device capable of preventing degradation of signal quality due to inclusion of noise and reducing the circuit scale. The constitution of a transmitter/receiver for transmitting/receiving a signal is fabricated on a semiconductor substrate (100). Part of the transmission and reception is performed by analog processing, and the other part is performed by digital processing. The digital processings of the transmission and reception are performed by using a common digital processing unit (20). A reception processing block (10) for analog processing of reception is disposed near a corner of the rectangular semiconductor substrate (100), and digital signal processing unit (20) is disposed near another corner not adjacent to the former corner.

## Description

### Technical Field

The present invention relates to a semiconductor device where a transmitter/receiver is formed on a semiconductor substrate.

### Background Art

A semiconductor device including both an analog circuit and a digital circuit on a same substrate has been known (refer to, for example, Patent Document 1). In general, a voltage level of a clock signal etc. output and input during the operation of a digital circuit, changes sharply from its high level to its low level or from its low level to its high level. For this reason, considering an analog circuit which performs predetermined processing to a minute received electric wave like the front end of a receiver, the noise generated when the voltage level of digital data changes cannot be disregarded.
[Patent Document 1]: Japanese Patent Laid Open No. 2003-37172 (pp.3-5, Figures 1 and 2)

### Disclosure of the Invention

Incidentally, in the semiconductor device disclosed in Patent Document 1 mentioned above, the clock line of a switching circuit is shortened by devising the arrangement of the switching circuit, thereby reducing inclusion of noise in the analog signal. However, as for signals (digital data) other than the clock signal input/output in a digital circuit, similarly, the voltage level changes steeply, thereby, there is possibility that sufficient effect for noise reduction may not be obtained only by shortening the clock line as the semiconductor device disclosed in Patent Document 1. In particular, when the inclusion of noise in the reception processing block of a receiver for receiving and amplifying a weak broadcast wave occurs, since the noise as well as the weak broadcast wave are amplified, there has been a problem that the signal quality has been degraded largely.

Moreover, the construction of a circuit fabricated on a semiconductor substrate, can be arbitrarily determined depending on the use and purpose thereof, however, when a transmitter/receiver for performing both of reception and transmission is fabricated on the semiconductor substrate, both of a construction of reception and a construction of transmission are required to be fabricated on the semiconductor substrate, thereby, there has been a problem of enlarging the circuit scale. Since, as the circuit scale becomes larger, the area of the semiconductor substrate also becomes larger, resulting in increase of material cost, thus it is desirable for the circuit scale to be reduced from the viewpoints of miniaturizing and cost reduction.

The present invention has been invented in view of these points, and the object of the invention is to provide a semiconductor device capable of preventing degradation of the signal quality due to inclusion of noise and reducing the circuit scale.

In order to solve the above mentioned problems, in the semiconductor device of the present invention, a construction of a transmitter/receiver for performing both of reception and transmission is fabricated on a semiconductor substrate, wherein, part of the reception and the transmission is performed by analog processing and the other part of them is performed by digital processing, respectively, and each digital processing of the reception and the transmission is performed by using a common digital processing block. Therefore, since when a function as the transmitter/receiver is fabricated on a semiconductor substrate, both of the reception and the transmission are processed by using the common digital processing block, it is not necessary to include a digital processing block for reception and a digital processing block for transmission, separately, enabling the circuit scale fabricated on the semiconductor substrate to be reduced.

Moreover, it is desirable for the semiconductor device to include a reception processing block for performing analog processing of the above mentioned reception and a transmission processing block for performing analog processing of the above mentioned transmission, wherein the reception processing block is disposed near one corner of a rectangular semiconductor substrate, and a digital processing block is disposed near another corner not adjacent to the former corner. Alternatively, it is desirable for the semiconductor device to include a reception processing block for performing analog processing of the reception and a transmission processing block for performing analog processing of the transmission, wherein the reception processing block is disposed near one end of a diagonal line of a semiconductor substrate having a rectangular shape, and a digital processing block is disposed near another end of the diagonal line. In general, since the reception processing block as the front end of a transmitter/receiver, performs processing such as extracting a received weak electric wave to amplify and transform it into an intermediate frequency signal, the quality of an output signal degrades largely when noise is included. For this reason, by disposing the digital processing block to be a noise source and the reception processing block on a semiconductor substrate separately, so as to be farthest from each other, the noise including in the reception processing block is reduced, thus enabling the quality of the input/output signal to be significantly improved.

Moreover, it is desirable that the above reception processing block subjects a received signal and a first oscillation signal to frequency mixing so as to perform frequency conversion, and that the transmission processing block generates a first and a second oscillation signals using a common oscillator, while performing modulation for modulating the second oscillation signal. This enables the circuit scale to be reduced, by sharing the oscillator.

Moreover, it is desirable to perform a first analog-digital conversion for converting an analog signal of the above reception to a digital data and inputting the digital data in a digital processing block, and a second analog-digital conversion for converting an analog signal of the transmission to digital data and inputting the digital data in the digital processing block, and to perform the first and the second analog-digital conversion by using a common analog-digital converter. Performing two types of analog-digital conversions required for each reception and transmission by using one analog-digital converter, enables the circuit scale to be reduced as compared to the case where analog-digital converters are included separately.

Moreover, it is desirable to perform a first digital-analog conversion for converting digital data output from a digital processing block of the above reception to an analog signal and a second digital-analog conversion for converting digital data of the transmission to an analog signal and to perform the first and the second digital-analog conversion by using a common digital-analog converter. Performing two kinds of digital-analog conversions required for each reception and transmission by using one digital- analog converter, enables the circuit scale to be reduced as compared to the case where digital-analog converters are included separately.

Moreover, it is desirable for the above-mentioned digital processing block to perform stereo modulation for generating stereo complex data from two types of input data, as digital processing of transmission. This enables stereo modulation to be performed without including a special analog circuit.

### Brief Description of the Drawings

Figure 1 is a block diagram of a semiconductor device of one embodiment, fabricated on a semiconductor device;
Figure 2 is a view illustrating a layout of the semiconductor device of the present embodiment; and
Figure 3 is a view illustrating another layout of the semiconductor device of the present embodiment.

### Description of Symbols

- 10: RECEPTION PROCESSING BLOCK
- 12, 40: ANALOG-DIGITAL CONVERTER (ADC)
- 20: DIGITAL SIGNAL PROCESSING UNIT (DSP)
- 30, 50: DIGITAL-ANALOG CONVERTER (DAC)
- 52: TRANSMISSION PROCESSING BLOCK
- 60: VOLTAGE CONTROLLED OSCILLATOR (VCO)
- 62: FREQUENCY SYNTHESIZER
- 100: SEMICONDUCTOR SUBSTRATE
- 200: ANTENNA
- 300: CRYSTAL OSCILLATOR

### Best Mode for Carrying Out the Invention

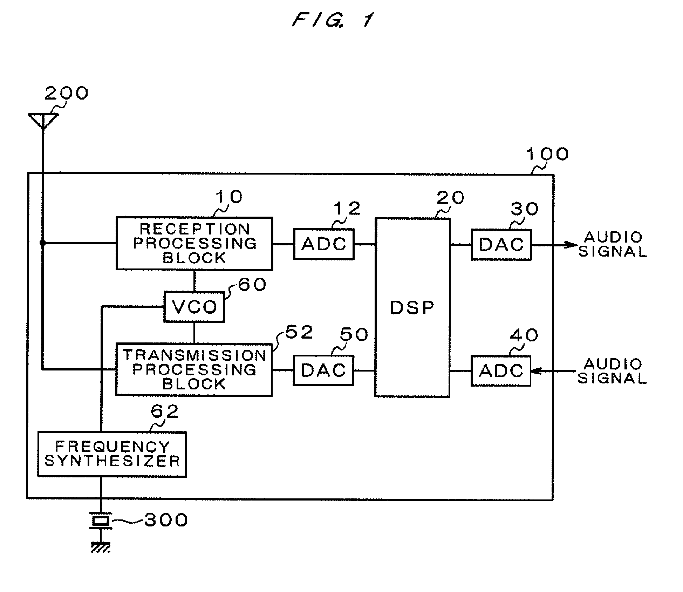

A semiconductor device of one embodiment of the present invention will be described in detail with reference to drawings. Figure 1 is a block diagram of the semiconductor device of one embodiment, fabricated on a semiconductor substrate. As shown in Figure 1, the semiconductor device of the present embodiment includes: a reception processing block 10; analog-digital converters (ADC) 12, 40; a digital signal processing unit (DSP) 20; digital-analog converters (DAC) 30, 50, a transmission processing block 52, a voltage controlled oscillator (VCO) 60; a frequency synthesizer 62; an antenna 200; and a crystal oscillator 300. The semiconductor device constructs a transmitter/receiver, in which each constituent except for the antenna 200 and the crystal oscillator 300 is fabricated on a semiconductor substrate 100 as a one-chip component, by means of a CMOS process, or an MOS process. Use of these processes enables miniaturization and lowering power consumption of the one-chip component fabricated on the semiconductor substrate 100 to be achieved. In the semiconductor device of the present embodiment, the constitution of the transmitter/receiver for performing both of transmission and reception is fabricated on the semiconductor substrate 100. In addition, part of the reception and the transmission is performed by analog processing, and the other part of them is performed by digital processing, respectively, the digital processing is performed by using the digital signal processing unit 20 as a common digital processing block.

The reception processing block 10 performs analog processing of reception, and performs frequency conversion to a broadcast wave signal (in addition, a modulation signal similar to the broadcast wave signal may also be used if it is transmitted from a broadcasting station or a home-use transmitter) received through the antenna 200, and outputs an intermediate frequency signal. A local oscillator is constituted by the voltage controlled oscillator 60, the frequency synthesizer 62, and the crystal oscillator 300, and a locally oscillated signal output from the voltage controlled oscillator 60 is input into the reception processing block 10. The reception processing block 10 is an analog circuit which performs frequency conversion by means of analog processing, carries out frequency mixture of the broadcast wave signal received through the antenna 200 and a local oscillation signal output from the voltage controlled oscillator 60, and generates an intermediate frequency signal as an analog signal. In addition, in the reception processing block 10, constituents such as a tuning circuit and an RF amplifier, as the front end of the receiver, are included. The intermediate frequency signal as an analog signal output from the reception processing block 10 is converted into digital data having a predetermined number of bits by the analog-digital converter 12.

The digital signal processing unit 20 is a digital processing block which performs digital processing to digital data, and performs predetermined demodulation to digital data output from the analog-digital converter 12. For example, the digital data after having been subjected to FM demodulation processing or FM stereo demodulation processing, is converted into an analog signal by the digital-analog converter 30. For example, when an audio signal is considered as the analog signal, the audio signal is output from a speaker or the like, after being amplified. Note that, the digital data generated by the demodulation processing performed by the digital signal processing unit 20 is not limited to the audio data. For example, a case where an image data is generated by the demodulation processing, may be considered.

Moreover, when an audio signal as an externally input analog signal is converted into digital data (audio data) by the analog-digital converter 40, and then input into the digital signal processing unit 20, the digital signal processing unit 20 performs a predetermined digital processing required for transmitting the modulation signal corresponds to the audio signal. For example, when L data and R data are input as the audio data, stereo demodulation processing combining the two data is performed. Moreover, processing for generating I component and Q component is performed. The digital data output from the digital signal processing unit 20 is converted into an analog signal by the digital-analog converter 50.

The transmission processing block 52 is an analog circuit which performs modulation processing as analog processing of transmission, modulates an oscillation signal output from the voltage controlled oscillator 60 using the analog signal input from the digital-analog converter 50, and transmits it from the antenna 200. For example, although, as a simple example, a case where FM modulation processing is performed can be considered, modulation processing of the other modulation method may also be performed. The voltage controlled oscillator 60, connected to both of the reception processing block 10 and the transmission processing block 52, generates a signal (a first oscillation signal) required for the reception by the reception processing block 10, and another signal (a second oscillation signal) required for the transmission by the transmission processing block 52.

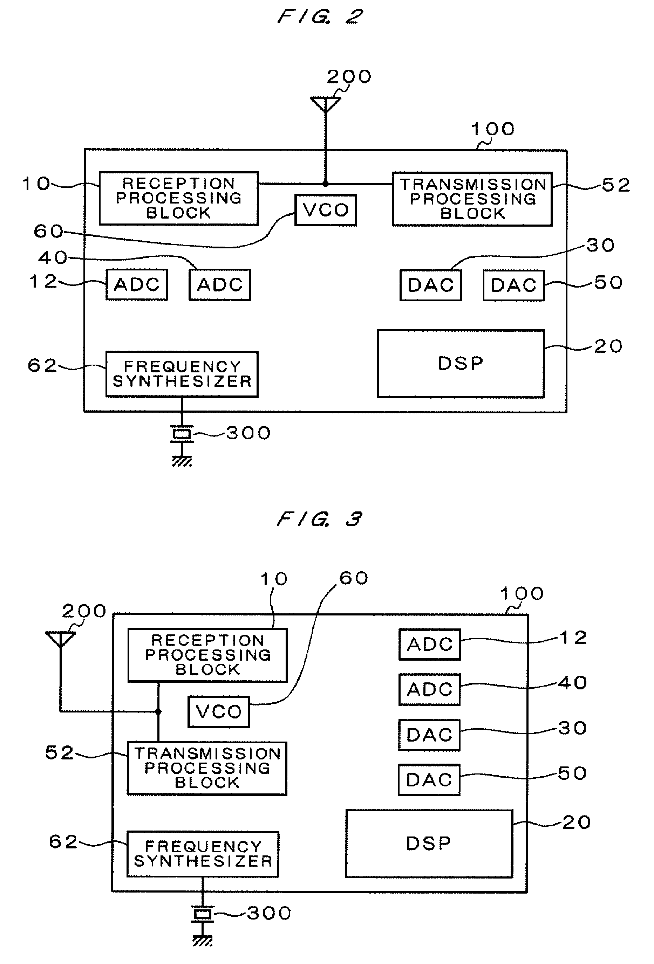

Figure 2 is a view illustrating the layout of the semiconductor device of the present embodiment. As illustrated in Figure 2, in the semiconductor device of the present embodiment, the reception processing block 10 is disposed near one corner of the rectangular semiconductor substrate 100, and the digital signal processing block 20 is disposed near another corner not adjacent to the former corner. In other words, in the semiconductor device of the present embodiment, the reception processing block 10 is disposed near the one end of a diagonal line of the rectangular semiconductor substrate 100, and the digital signal processing unit 20 is disposed near the another end of the diagonal line.

Further, specifically, in the rectangular semiconductor substrate 100 illustrated in Figure 2, the reception processing block 10 is disposed near the left upper corner of the rectangle shape, and the digital signal processing block 20 is disposed near the right lower corner. The transmission processing block 52 is disposed near the right upper corner, and the frequency synthesizer 62 is disposed near the left lower corner. Moreover, near the center between the reception processing block 10 and the transmission processing block 52 which are disposed along the upper side of the rectangular shape, the voltage controlled oscillator 60 is disposed so as to prevent the length of a wiring connecting each of the reception processing block 10 and the transmission processing block 52 and the voltage controlled oscillator 60 from being unnecessarily long. Further, the analog-digital converters 12 and 40 and the digital-analog converters 30 and 50 are disposed in a traverse line near the center of the rectangular shape, therefore, a circuit group consisting of the reception processing block 10, a transmission processing block 52, and the voltage controlled oscillator 60, and another circuit group consisting of the digital signal processing unit 20 and the frequency synthesizer 62 are separated mutually.

Figure 3 is a view illustrating another layout of the semiconductor device. In the semiconductor device illustrated in Figure 3, similar to the layout illustrated in Figure 1, the reception processing block 10 is disposed near the left upper corner of the rectangular shape, and the digital signal processing unit 20 is disposed near the right lower corner. Moreover, the analog-digital converters 12 and 40 and the digital-analog converters 30 and 50 are disposed near the right upper corner, and the frequency synthesizer 62 is disposed near the left lower corner. Moreover, between the reception processing block 10 and the frequency synthesizer 62, the voltage controlled oscillator 60 and the transmission processing block 52 are disposed.

In this manner, by disposing the digital signal processing unit 20 to be a noise source and the reception processing block 10, separately, so as to be farthest from each other, noise included in the reception processing block 10 can be reduced, resulting in great improvement of the signal quality input/output in the reception processing block 10.

Moreover, since both of reception and transmission are processed using the common digital signal processing unit 20, it is not necessary to have separately a digital signal processing unit for the reception, and a digital signal processing unit for a transmission, thereby enabling the scale of the circuit fabricated on the semiconductor substrate 100 to be reduced. In addition, generating on oscillation signal required for the reception and the transmission using a common voltage controlled oscillator 60, enables the circuit scale to be reduced by sharing the voltage controlled oscillator 60. Moreover, performing stereo modulation using the digital signal processing unit 20, enables the stereo modulation to be performed without using a special analog circuit, and further the circuit scale to be reduced.

In addition, the present invention is not limited to the above-mentioned embodiment, instead, various modifications are possible within the gist of the present invention. Although in the above-mentioned embodiment, as illustrated in Figures 2 and 3, a case where two types of analog-digital converters 12 and 40 are included separately, one common analog-digital converter (referred to as a "common analog-digital converter") may be used so as to perform operations of the two analog-digital converters 12 and 40. For example, when the reception and the transmission are not performed at the same time, the common analog-digital converter may be used as the analog-digital converter 12 during performing the reception, and it may be used as the analog-digital converter 40 during performing the transmission. Moreover, when the reception and the transmission are performed at the same time, the processing of the common analog-digital converter may be performed by time sharing.

Similarly, as shown in Figures 2 or 3, a case where the two digital-analog converters 30 and 50 are separately included has been described, however, one common digital-analog converter (referred to as a "common digital-analog converter") may be used so as to perform the operations of the two digital-analog converters 30 and 50. For example, when the reception and the transmission are not performed at the same time, the common digital-analog converter may be used as the digital-analog converter 30 during performing the reception, and it may be used as the digital-analog converter 50 during performing the transmission. Moreover, when the reception and the transmission are performed at the same time, the processing of the common digital-analog converter may be performed by time sharing.

In this manner, use of the common analog-digital converter and the common digital-analog converter enables the circuit scale to be reduced. Moreover, as mentioned-above, sharing the digital signal processing unit 20, the voltage controlled oscillator 60, the common analog-digital converter, and the common digital-analog converter in the operations of reception and transmission, has also an effect of reducing power consumption, as compared to the case where they are included separately.

### Industrial Applicability

According to the present invention, when the function as a transmitter/receiver is fabricated on one semiconductor substrate, since both of reception and transmission are processed by using a common digital processing block, it is not necessary to include a digital processing block for reception and a digital processing block for transmission separately, enabling the scale of the circuit fabricated on the semiconductor substrate to be reduced.

## Claims

1. A semiconductor device in which a construction performing both of reception and transmission is fabricated on a semiconductor substrate, wherein
part of the reception and the transmission is performed by analog processing, and the other part of them is performed by digital processing; and
each of the digital processing of the reception and the transmission is performed by using a common digital processing block.

2. The semiconductor device according to claim 1, comprising:
a reception processing block for performing the analog processing of the reception and a transmission processing block for performing the analog processing of the transmission; wherein
the reception processing block is disposed near one corner of the rectangular semiconductor substrate, and the digital processing block is disposed near another corner not adjacent to the former corner.

3. The semiconductor device according to claim 2, wherein
the reception processing block performs frequency mixing of a received signal and a first oscillation signal so as to perform frequency conversion, and the transmission processing block performs modulation for modulating a second oscillation signal; and
the first oscillation signal and the second oscillation signal are generated by using a common oscillator.

4. The semiconductor device according to claim 1, comprising:
a reception processing block for performing the analog processing of the reception and a transmission processing block for performing the analog processing of the transmission; wherein
the reception processing block is disposed near one end of a diagonal line of the rectangular semiconductor substrate, and the digital processing block is disposed near another end of the diagonal line.

5. The semiconductor device according to claim 4, wherein
the reception processing block performs frequency mixing of a received signal and a first oscillation signal so as to perform frequency conversion, and the transmission processing block performs modulation for modulating a second oscillation signal; and
the first oscillation signal and the second oscillation signal are generated by using a common oscillator.

6. The semiconductor device according to claim 1, wherein
a first analog-digital conversion for converting an analog signal of the reception to a digital data and inputting it in the digital processing block, and a second analog-digital conversion for converting an analog signal of the transmission to a digital data and inputting it in the digital processing block, are performed; and
the first analog-digital conversion and the second analog-digital conversion are performed by using a common analog-digital converter.

7. The semiconductor device according to claim 1, wherein
a first digital-analog conversion for converting digital data output from the digital processing block of the reception to an analog signal, and a second digital-analog conversion for converting digital data output from the digital processing block of the transmission to an analog signal, are performed; and
the first digital-analog conversion and the second digital-analog conversion are performed by using a common digital-analog converter.

8. The semiconductor device according to claim 1, wherein
the digital processing block performs stereo modulation for generating stereo complex data from two-types of data input as the digital processing of the transmission.

9. The semiconductor device according to claim 1, wherein
a construction performing both of the reception and the transmission is fabricated on the semiconductor substrate by means of a CMOS process or an MOS process.

10. A transmitter/receiver constructed by using the semiconductor device according to claim 1.
